(19) **Europäisches Patentamt / European Patent Office / Office européen des brevets**

(11) **EP 4 567 606 A1**

(12) # EUROPEAN PATENT APPLICATION

(43) Date of publication:
**11.06.2025 Bulletin 2025/24**

(21) Application number: **24209621.2**

(22) Date of filing: **29.10.2024**

(51) International Patent Classification (IPC):
**G06F 11/32** (2006.01)   **G06F 8/34** (2018.01)
**G06F 11/3668** (2025.01)   **G06F 30/20** (2020.01)
**G06F 30/12** (2020.01)   **G06F 30/15** (2020.01)

(52) Cooperative Patent Classification (CPC):
**G06F 11/323; G06F 8/34; G06F 11/3692;**
**G06F 30/12; G06F 30/15; G06F 30/20;**
G06F 11/3688; G06F 11/3698

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **06.11.2023   CN 202311468719**

(71) Applicant: **Shanghai Tosun Technology Ltd.**
**Shanghai 201804 (CN)**

(72) Inventors:
• **Liu, Chu**
  **Shanghai, 200000 (CN)**
• **Xie, Yueyin**
  **Shanghai, 200000 (CN)**
• **Mo, Mang**
  **Shanghai, 200000 (CN)**

(74) Representative: **Sun, Yanan**
**Hassler International Germany GmbH**
**Textorstraße 91**
**60596 Frankfurt am Main (DE)**

(54) **PROGRAM STEP VISUALIZATION IMPLEMENTATION METHOD AND SYSTEM IN A VEHICLE SIMULATION TEST PROCESS**

(57)   The present disclosure relates to the field of vehicle simulation test programs, and in particular to a program step visualization implementation method in a simulation test process. The method includes: respectively setting a mark parameter of an activation state or a non-activation state corresponding to the corresponding execution state for each execution box in a graphics program; when the execution state of the execution box changes, changing a display mark of the execution box into an activation state mark corresponding to the new execution state; and when a current execution state of the execution box remains unchanged for a preset period of time, changing the display mark of the execution box from the activation state mark into a non-activation state mark.

EP 4 567 606 A1

**Description**

**CROSS REFERENCE TO RELATED APPLICATION**

This application is based upon and claims foreign priority to Chinese Patent Application No. 202311468719.3, filed on November 6, 2023, the entire content of which is incorporated herein by reference.

**TECHNICAL FIELD**

The present disclosure relates to the field of vehicle simulation test programs, and in particular to a program step visualization implementation method and system in a simulation test process.

**BACKGROUND**

In the vehicle field, the vehicle simulation test programs are usually executed by loading vehicle C codes, which is essentially different from the graphics programs in other fields such as robotics field. The graphics programs in the robotics field are mainly set up with a compiled framework to run without considering code generation; whereas the graphics programs formed by the vehicle C codes are considered with the purpose of generating embedded end codes. Therefore, the graphics programs in other fields cannot be directly ported to the graphics programs in the vehicle field. Therefore, the C code-based vehicle simulation test programs have field-specific uniqueness and also can bring about the technical problems specific to the simulation test programs, that is, the simulation test programs cannot visually display a running state during a running process, which will bring the following problems.

It is unknown that which action is being executed by the current test program and whether the executed action is destructive. If execution of a destructive action is interrupted, a tested workpiece or test system may be destroyed.

It is unknown whether the current test program encounters a test determination failure and what type of determination failure it is. The conventional method is to seek in a log record, leading to a low efficiency.

In the test logics with many branches and cycles, it is unknown that the test logics runs through which branches and the test logics enters which state.

**SUMMARY**

The present disclosure provides to a program step visualization implementation method in a C code-based simulation test process. The method includes:

respectively setting a mark parameter of an activation state or a non-activation state corresponding to a corresponding execution state for each execution box in a C code-based graphics program;
when the execution state of the execution box changes, changing a display mark of the execution box into an activation state mark corresponding to a new execution state; and when a current execution state of the execution box remains unchanged for a preset time period, changing the display mark of the execution box from the activation state mark into a non-activation state mark.

According to another aspect, the present disclosure provides a program step visualization implementation system in a C code-based vehicle simulation test process, comprising a computer device, wherein the computer device further comprises:

a setting module, configured to respectively set a mark parameter of an activation state or a non-activation state corresponding to a corresponding execution state for each execution box in a C code-based graphics program; and
a marking module, configured to: when the execution state of the execution box changes, change a display mark of the execution box into an activation state mark corresponding to a new execution state; and when a current execution state of the execution box remains unchanged for a preset time period, change the display mark of the execution box from the activation state mark into a non-activation state mark.

The summary of the present disclosure aims to provide brief descriptions for the subjects of the specification. Thus, it should be understood that the above features are only illustrative and shall not be interpreted as narrowing the scope or essence of the subject of the specification in any way.

Other features, aspects and advantages of the subjects of the present disclosure will become apparent by way of the specific embodiments, drawings and claims.

**BRIEF DESCRIPTION OF THE DRAWINGS**

In order to more clearly describe the technical solutions in the embodiments of the present disclosure or in the prior arts, the drawings required for descriptions of the specific embodiments or the prior arts will be briefly introduced. Apparently, the drawings described hereunder are only some embodiments of the present disclosure. Those skilled in the arts can obtain other drawings based on these drawings without making creative work.

FIG. 1 is a step diagram illustrating a program step visualization implementation method in a simulation test process according to one or more embodiments of the present disclosure.

FIG. 2 is a schematic diagram illustrating a case of a program step visualization implementation method in a simulation test process according to one or more embodiments of the present disclosure.

FIG. 3 is a schematic diagram illustrating a case of a program step visualization implementation method in a simulation test process according to one or more embodiments of the present disclosure.

FIG. 4 is a schematic diagram illustrating a case of a program step visualization implementation method in a simulation test process according to one or more embodiments of the present disclosure.

FIG. 5 is a schematic diagram illustrating a case of a program step visualization implementation method in a simulation test process according to one or more embodiments of the present disclosure.

FIG. 6 is a schematic diagram illustrating a case of a program step visualization implementation method in a simulation test process according to one or more embodiments of the present disclosure.

FIG. 7 is a schematic diagram illustrating a case of a program step visualization implementation method in a simulation test process according to one or more embodiments of the present disclosure.

FIG. 8 is a schematic diagram illustrating a case of a program step visualization implementation method in a simulation test process according to one or more embodiments of the present disclosure.

FIG. 9 is a schematic diagram illustrating a case of a program step visualization implementation method in a simulation test process according to one or more embodiments of the present disclosure.

FIG. 10 is a schematic diagram illustrating a case of a program step visualization implementation method in a simulation test process according to one or more embodiments of the present disclosure.

FIG. 11 is a schematic diagram illustrating a case of a program step visualization implementation method in a simulation test process according to one or more embodiments of the present disclosure.

FIG. 12 is a principle block diagram illustrating a program step visualization implementation system in a C code-based vehicle simulation test process according to one or more embodiments of the present disclosure.

FIG. 13 is a principle block diagram illustrating an electronic device according to one or more embodiments of the present disclosure.

FIG. 14 is a principle block diagram illustrating an electronic device according to one or more embodiments of the present disclosure.

**DETAILED DESCRIPTION OF THE EMBODIMENTS**

In order to make the object, technical solutions and advantages of the embodiments of the present disclosure clearer, the technical solutions of the present disclosure will be fully and clearly described in combination with drawings. Apparently, the embodiments described herein are only some embodiments rather than all embodiments. All other embodiments obtained by those skilled in the art based on these drawings without making creative work shall fall within the scope of protection of the present disclosure.

Therefore, the C code-based vehicle simulation test programs have field-specific uniqueness and also can bring about the technical problems specific to the simulation test programs, that is, the simulation test programs cannot visually display a running state during a running process, which will bring the following problems.

It is unknown that which action is being executed by the current test program and whether the executed action is destructive. If execution of a destructive action is interrupted, a tested workpiece or test system may be destroyed.

It is unknown whether the current test program encounters a test determination failure and what type of determination failure it is. The conventional method is to seek in a log record, leading to a low efficiency.

In the test logics with many branches and cycles, it is unknown that the test logics runs through which branches and the test logics enters which state.

As a result, one or more embodiments provide a program step visualization implementation method in a simulation test process. The method includes: respectively setting a mark parameter of an activation state or a non-activation state corresponding to a corresponding execution state for each execution box in a graphics program; when the execution state of the execution box changes, changing a display mark of the execution box into an activation state mark corresponding to a new execution state; and when a current execution state of the execution box remains unchanged for a preset time period, changing the display mark of the execution box from the activation state mark into a non-activation state mark.

In the program step visualization implementation method in the simulation test process, the steps executed by the current program can be visually displayed during a running period by using the graphics program-based visualization method.

Various non-limiting implementations of the embodiments of the present disclosure will be detailed below in combination with drawings.

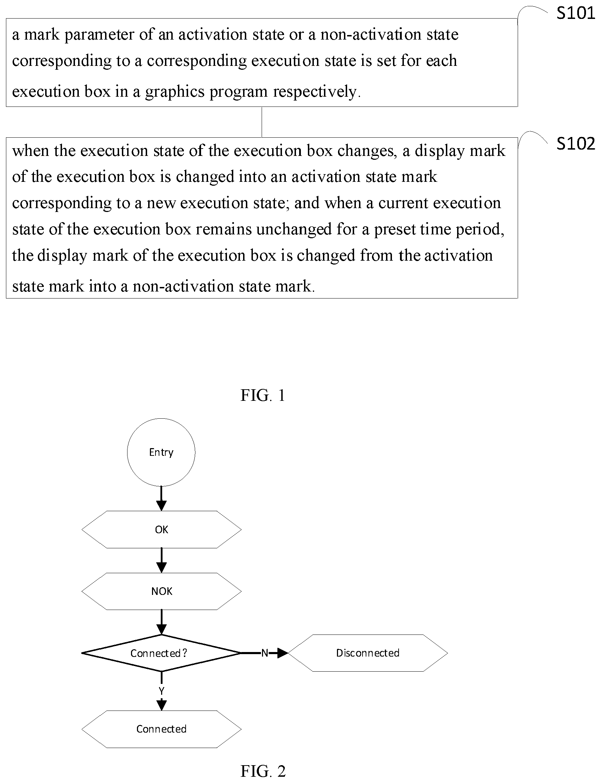

As shown in FIG. 1, one or more embodiments provide a program step visualization implementation method in a C code-based simulation test process. The method includes the following steps.

At step S101, a mark parameter of an activation state or a non-activation state corresponding to a corresponding execution state is set for each execution box in a C code-based graphics program respectively.

At step S102, when the execution state of the execution box changes, a display mark of the execution box is changed into an activation state mark corresponding to a new execution state; and when a current execution state of the execution box remains unchanged for a preset time period, the display mark of the execution box is changed from the activation state mark into a non-activation state mark.

Specifically, the activation state refers to a state conversion of the current execution box from un-executed by the test system to executed by the test system and a current moment is within a preset time following a state conversion moment. The non-activation state refers to that the current execution box is not executed by the test system or although the current execution box is executed by the test system, a time period from the state conversion moment to the current moment exceeds the preset time.

Setting the activation state or the non-activation state is to highlight the latest running state of the program, namely, which execution unit is being executed by the current program, whether the executed execution unit has an error report, and how long the last success or error report is from the current moment. Setting the activation state or the non-activation state intensifies the visual effect of the running state and the user can monitor a test process by a screen or board and track a direction of the test flow and also can pinpoint a specific execution unit in the first time after the program skips or reports error, so as to improve the monitoring and troubleshooting efficiency during the test process.

In addition, after the execution state of the execution box is changed into an activation state mark corresponding to a new execution state, if the activation state is kept all the time, the user is unclear about whether the current activation state is generated previously or just now, or one time or multiple times or continuously or the like. If the activation state remains unchanged, it cannot achieve the effect of prompting the user to focus on event. Therefore, when the current execution state of the execution box remains unchanged for a preset time period, the display mark of the execution box is changed from the activation state mark into a non-activation state mark. In this case, once the execution state changes, the execution unit switches from the non-activation state to the activation state which is highlighted with a bright color to attract the attention of the user. When the execution state remains unchanged for long, the highlight color will fade away to avoid continuing occupying the attention of the user, so as to improve the monitoring efficiency of the test flow.

In some embodiments, the mark parameter includes a color parameter and a pattern parameter.

In some embodiments, when the mark parameter is a color parameter, the program step visualization implementation method in the simulation test process includes: respectively setting a color parameter of an activation state or a non-activation state corresponding to a corresponding execution state for each execution box in the C code-based graphics program; when the execution state of the execution box changes, changing a display color of the execution box into an activation state color corresponding to a new execution state; when the current execution state of the execution box remains unchanged, changing the display color of the execution box from the activation state color into a non-activation state color gradually.

In some embodiments, a pattern parameter type, for example, includes but not limited to: a shape pattern of the execution box and a background fill pattern of the execution box; the shape pattern of the execution box includes, for example, square shape, circle shape and star shape and the like; the background fill pattern of the execution box does not include a background fill pattern of a pure color but specifically includes a line fill, a circle fill and a triangle fill and the like.

In some embodiments, when the mark parameter is a pattern parameter, for example, a shape pattern of the execution box, the program step visualization implementation method in the simulation test process includes:

respectively setting a pattern parameter of an activation state or a non-activation state corresponding to a corresponding execution state for each execution box in the C code-based graphics program; wherein, it is supposed that, in an unexecuted state, the activation state of the execution box is rectangle; in an in-execution state, the activation state of the execution box is square and the non-activation state is circle;

when the execution state of the execution box changes, for example, from the un-executed state to the in-execution state, the shape pattern of the execution box changes from rectangle to the activation state pattern, e.g. square, corresponding to the new execution state; when the current execution state of the execution box remains unchanged, the shape pattern of the execution box gradually changes from the activation state shape pattern, e.g. square into the non-activation state shape pattern, e.g. circle.

In some embodiments, when the mark parameter is a pattern parameter, for example, a background fill pattern of the execution box, the program step visualization implementation method in the simulation test process includes:

respectively setting a pattern parameter of an activation state or a non-activation state corresponding to a corresponding execution box for each execution box in the C code-based graphics program; wherein it is supposed that, in an unexecuted state, the activation state of the execution box is line fill; in an in-execution state, the activation state of the execution box is circle fill and the non-activation state is triangle fill;

when the execution state of the execution box changes, for example, from the un-executed state to the in-execution state, the background fill pattern of the execution box changes from line fill to the activation background fill pattern, for example, circle fill, corresponding to the new execution state; when the current execution state of the execution box remains unchanged, the background fill pattern of the execution box gradually changes from the activation state background fill pattern, e.g. circle fill, into the non-activation state background fill pattern, e.g. triangle fill.

In some embodiments, the color parameter and the pattern parameter may also be combined for expression based on requirements, for example, in a case of triangle fill, color change may be combined; in a case of change of the shape pattern of the execution box, color change may also be combined similarly.

In some embodiments, the execution state includes an un-executed state, an in-execution state, execution completion with execution result marked as passed state, execution completion with execution result marked as failed state, an execution-interrupted state, and ongoing execution marked as failed state.

The color parameters of the activation state or the non-activation state corresponding to the execution state of each execution box are exemplified below:

| Execution state | Activation state color (RGB) | Non-activation state color (RGB) |
|---|---|---|
| (1) unexecuted state | Blue C4E6FF | Blue C4E6FF |
| (2) in-execution state | Yellow FFC000 | Light yellow FFE89D |
| (3) ongoing execution marked as failed state | Red FF0000 | Pink FFB7B9 |
| (4) execution completion with execution result marked as passed state | Green 92D050 | Lake green BCE2E4 |
| (5) execution completion with execution result marked as failed state | Red FF0000 | Pink FFB7B9 |
| (6) execution-interrupted state | Purple A200FF | Light purple E5B7FF |

With several cases, the circumstance that when the execution state of the execution box changes, the display color of the execution box changes into the activation state color corresponding to the new execution state will be described in details below.

As shown in FIG. 2, the execution box "Entry" and the execution box "OK" are in a state of execution completion with execution result marked as passed state, and the current display colors of them are green; the execution box "NOK" is in a state of execution completion with execution result marked as failed state, and the current display color is red; the execution box "Connected?" is in an in-execution state and the current display color is yellow; the execution box "Connected" and the execution box "Disconnected" are in an un-executed state, and the current display colors of them are blue.

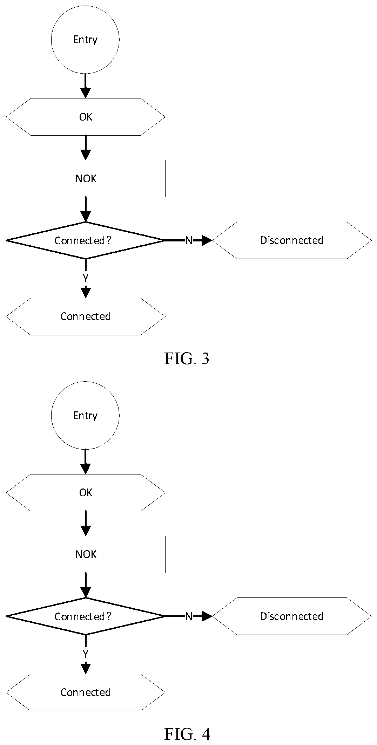

As shown in FIG. 3, the execution box "Entry" and the execution box "OK" are in a state of execution completion with execution result marked as passed state, and the current display colors of them are green; the execution box "NOK" is in a state of ongoing execution marked as failed state, and the current display color is red; the execution box "Connected?", the execution box "Connected", and the execution box "Disconnected" are all in an un-executed state and the current display colors of them are blue.

As shown in FIG. 4, the execution box "Entry" and the execution box "OK" are in a state of execution completion with execution result marked as passed state, and the current display colors of them are green; the execution box "NOK" is in an execution-interrupted state, and the current display color is purple; the execution box "Connected?", the execution box "Connected", and the execution box "Disconnected" are all in an un-executed state and the current display colors of them are blue.

With several cases, the circumstance that when the current execution state of the execution box remains unchanged, the display color of the execution box gradually changes from the activation state color into a non-activation state color will be described in details below.

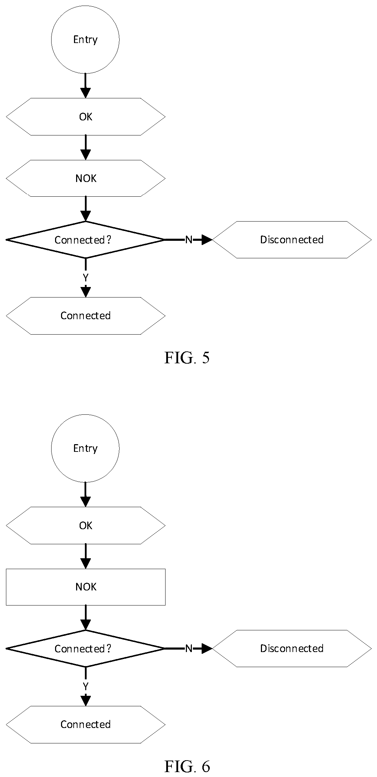

As shown in FIG. 5, the execution box "Entry" and the execution box "OK" remain in a state of execution completion with execution result marked as passed state, and the current display colors of them change gradually from green to lake green; the execution box "NOK" remains in a state of execution completion with execution result marked as failed state, and the current display color gradually changes from red to light pink; the execution box "Connected?" is in an in-execution state and the current display color changes from yellow to light yellow; the execution box "Connected" and the execution box "Disconnected" remain in an un-executed state, and the current display colors of them keep blue.

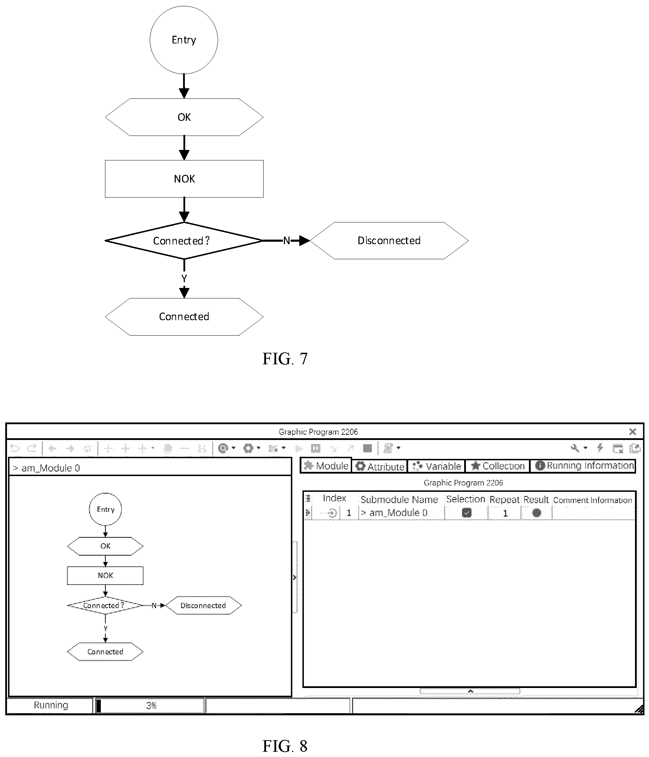

As shown in FIG. 6, the execution box "Entry" and the execution box "OK" remain in a state of execution completion with execution result marked as passed state, and the current display colors of them change from green to lake green; the execution box "NOK" remains in a state of ongoing execution marked as failed state, and the current display color changes gradually from red to light pink; the execution box "Connected?", the execution box "Connected", and the execution box "Disconnected" all remain in an un-executed state and the current display colors of them keep blue. As shown in FIG. 7, the execution box "Entry" and the execution box "OK" remain in a state of execution completion with execution result marked as passed state, and the current display colors of them change from green to lake green; the execution box "NOK" remains in an execution-interrupted state, and the current display color changes gradually from purple to light purple; the execution box "Connected?", the execution box "Connected", and the execution box "Disconnected" all remain in an un-executed state and the current display colors of them keep blue.

In some embodiments, when the current execution state of the execution box remains unchanged, a method of gradually changing the display color of the execution box from the activation state color into the non-activation state color includes:

obtaining an execution time Ta of the current execution state;
setting a time span of gradually changing from the activation state color into the non-activation state color to T0;
taking three components R1, G1 and B1 from Red Green Blue (RGB) of the activation state color;
taking three components R2, G2 and B2 from RGB of the non-activation state color; calculating three components R0, G0 and B0 of RGB of the display color of the execution box;
combining the three components R0, G0 and B0 as the display color of the execution box corresponding to the current execution state.

With one case, the circumstance that when the current execution state of the execution box remains unchanged, the display color of the execution box gradually changes from the activation state color into the non-activation state color will be described in details below.

If the test system runs one execution unit, its function is to wait for a signal 1 changing from 0 to 1, with a waiting expiration time being 10 seconds. If the execution unit is run in the third second and the signal 1 is 0 all the time, the execution box will be in a waiting state all the time in the 10 seconds to come, namely, the execution state remains unchanged in the 10 seconds to come. Thus, the display color of the execution box gradually changes from the activation state color to the non-activation state color through the following process:

The execution time that the execution box enables the execution state is obtained as Ta= 3 seconds; in the third second, the execution state is in an activation state and the current display color of the execution box is yellow FFC000 and its corresponding non-activation state color is light yellow FFE89D.

The time span of gradually changing from the activation state color to the non-activation state color is set to T0 = 5 seconds.

Three components R1, G1 and B1 are taken from the hexadecimal FFC000 of the activation state color value, where the three components of the RGB are R1=0xFF(255), G1=0xC0(192), and B1=0x00(0).

Three components R2, G2 and B2 are taken from the hexadecimal FFE89D of the non-activation state color value, where the three components of the RGB are R2=0xFF(255), G2=0xE8(232), and B2=0x9D(157).

Based on the activation state color, the non-activation state color and the current elapsed time T, the three components of the display color RGB of the execution box are calculated to, for example, know the current execution time Tb of the execution box reaches the 5.5th second, equivalent to Ta being executed further 2.5 seconds, i.e. the elapsed time T=2.5 seconds. The three components R0, G0 and B0 of the display color of the execution box at this time, i.e. R0=0xFF (255), G0=0xD4(212), B0=0x4E(78), are calculated.

The three components R0, G0 and B0 are combined to obtain a hexadecimal FFD44E as the display color of the execution box corresponding to the current execution state, namely, the color FFC000 corresponding to the activation state may gradually change into the color FFE89D corresponding to the non-activation state over time. During the time elapse, execution is performed further 2.5 seconds, that is, T=2.5 seconds, and the color displayed by the execution box changes from FFC000 to FFD44E.

In some embodiments, a method of calculating the three components R0, G0, B0 of the RGB of the display color of the execution box includes:

calculating an elapsed time T;

wherein, when T>T0, R0= R2, G0= G2, B0= B2; otherwise,

$$R0 = T/T0*(R2- R1)+ R1;$$

$$G0 = T/T0*(G2- G1)+ G1;$$

$$B0 = T/T0*(B2- B1)+ B1.$$

With one case, the method of calculating the three components R0, G0, B0 of the RGB of the display color of the execution box will be described in details below.

If the test system runs one execution unit, its function is to wait for a signal 1 changing from 0 to 1, with a waiting expiration time being 10 seconds. If the execution unit is run in the third second and the signal 1 is 0 all the time, the execution box will be in a waiting state all the time in the 10 seconds to come, namely, the execution state remains unchanged in the 10 seconds to come. Thus, the display color of the execution box gradually changes from the activation state color to the non-activation state color through the following process:

The execution time that the execution box enables the execution state is obtained as Ta= 3 seconds; in the third second, the execution state is in an activation state and the current display color of the execution box is yellow FFC000 and its corresponding non-activation state color is light yellow FFE89D.

The time span of gradually changing from the activation state color to the non-activation state color is set to T0 = 5 seconds.

Three components R1, G1 and B1 are taken from the hexadecimal FFC000 of the activation state color value, where the three components of the RGB are R1=0xFF(255), G1=0xC0(192), and B1=0x00(0).

Three components R2, G2 and B2 are taken from the hexadecimal FFE89D of the non-activation state color value, where the three components of the RGB are R2=0xFF(255), G2=0xE8(232), and B2=0x9D(157).

A method of, based on the activation state color, the non-activation state color and the current elapsed time, calculating the three components of the display color RGB of the execution box includes:

The current elapsed time T=current time - the execution time that the execution box enables the execution state, that is, T=Tb-Ta. When T>T0, R0= R2, G0= G2, B0= B2, namely, the color of the execution box is locked as hexadecimal FFE89D and will not change any longer, and otherwise, the color of the execution box will be calculated based on the following formula:

$$R0 = T/T0*(R2- R1)+ R1$$

$$G0 = T/T0*(G2- G1)+ G1$$

$$B0 = T/T0*(B2- B1)+ B1$$

namely,

$$R0 = 255$$

$$G0 = T*8 + 192$$

$$B0 = T/5*157$$

For example, when the current time Tb=5 seconds, the current elapsed time T = Tb - Ta =2 seconds, thus R0=255, G0=208, B0=62; hence, the color of the execution box is the hexadecimal FFD03E.

In some embodiments, the color parameters of the activation state or the non-activation state corresponding to the execution completion with execution result marked as failed state and the ongoing execution marked as failed state are same and both are anomaly colors; and,

if the execution box is in a unit group, when the execution state of any one execution box in the unit group is the execution completion with execution result marked as failed state or the ongoing execution marked as failed state, the display color of the unit group is an anomaly color.

With one case, a method in which the color parameters of the activation state or the non-activation state corresponding to the execution completion with execution result marked as failed state and the ongoing execution marked as failed state are same and both are anomaly colors; and if the execution box is in a unit group, when the execution state of any one execution box in the unit group is the execution completion with execution result marked as failed state or the ongoing execution marked as failed state, the display color of the unit group is an anomaly color, will be described in details below.

If the test system runs one execution unit, its function is to call one API function which has a delay of 10 seconds during which whether the signal 1 is 1 is determined in real time. If the signal 1 is not 1, another API function "test.set_verdict_nok" is called to determine a result failure. If the signal 1 is 0 all the time, when the execution unit calls the API function, it is firstly marked as in-execution state, namely, the display color is a hexadecimal FFC000, and then marked as execution completion with execution result marked as failed state, and thus, the color of the execution box of the execution unit will be immediately changed to hexadecimal FF0000, which is an anomaly color. In 0 to 5 seconds to come, the color of the execution box of the execution unit will gradually change from the anomaly color under the activation state (hexadecimal FF0000) to an anomaly color under the non-activation state (hexadecimal FFB7B9) and remain unchanged in 5 to 10 seconds to come.

As shown in FIG. 8, the execution box "NOK" is an execution unit run by the current system. In the drawing, it is shown that the execution box just enters an execution state and is marked as execution completion with execution result marked as failed state.

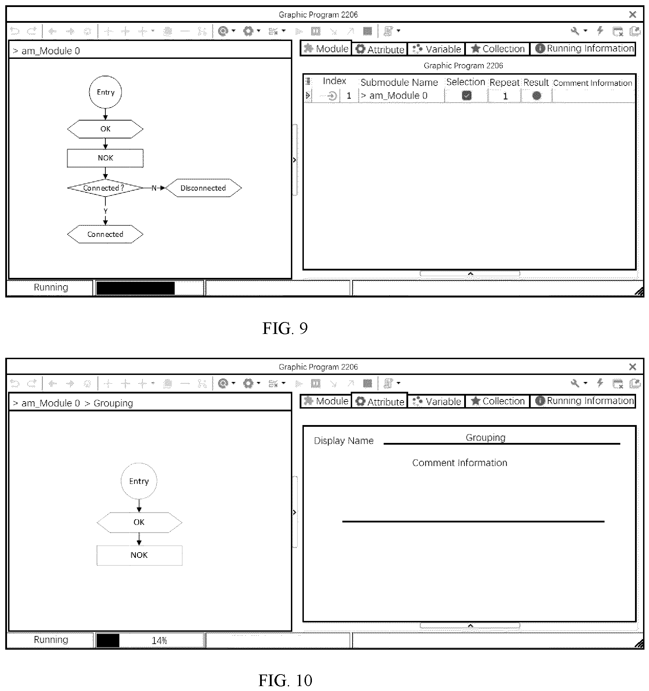

As shown in FIG. 9, the execution box "NOK" is an execution unit run by the current system. In the drawing, it is shown that the execution box has kept the execution state for seven seconds and is marked as execution completion with execution result marked as failed state.

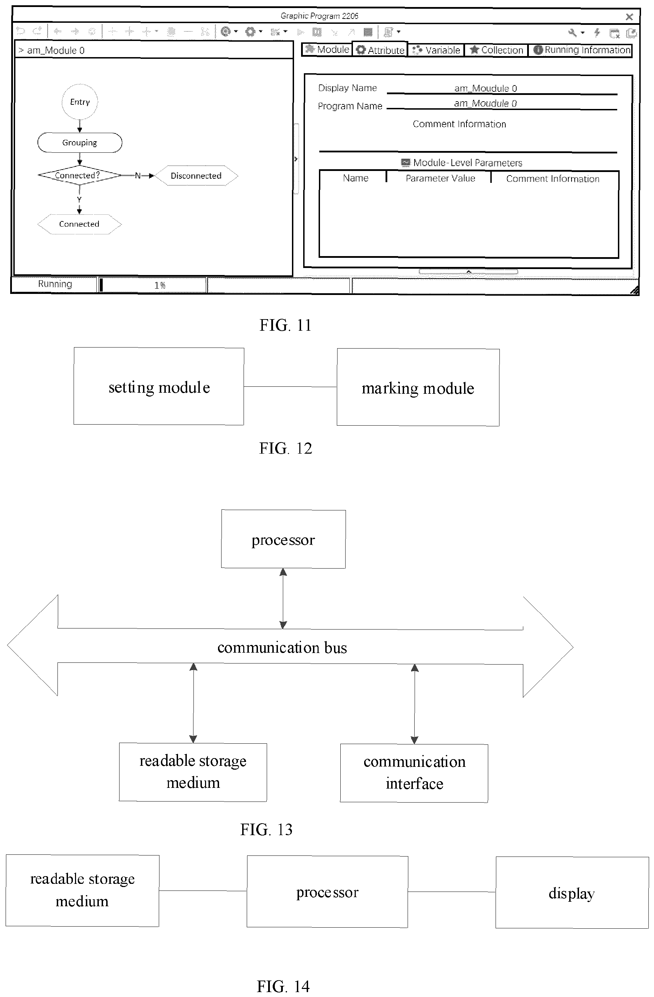

As shown in FIGS. 10 and 11, when the execution box "NOK" is in one execution unit group, the execution box is marked as failed during execution process, and the display color of the execution box is an anomaly color. In this case, the execution unit group containing the execution box is also marked as failed, and the display color of the unit group of the execution box is an anomaly color.

As shown in FIG. 12, one or more embodiments further provide a program step visualization implementation system in a C code-based vehicle simulation test process. The system includes a computer device, which is configured to include:

> a setting module, configured to respectively set a mark parameter of an activation state or a non-activation state corresponding to a corresponding execution state for each execution box in a C code-based graphics program;
> a marking module, configured to: when the execution state of the execution box changes, change a display mark of the execution box into an activation state mark corresponding to a new execution state; and when a current execution state of the execution box remains unchanged for a preset time period, change the display mark of the execution box from the activation state mark into a non-activation state mark.

The implementation of the specific functions of the setting module and the marking module in the computer device can be referred to the contents of the above program step visualization implementation method in the simulation test process and will not be repeated herein.

The electronic device in the embodiments of the present disclosure will be described from the angle of hardware processing below.

The embodiments of the present disclosure do not make any limitation to the specific implementation of the electronic device.

As shown in FIG. 13, one or more embodiments further provide an electronic device, including a processor, a readable storage medium, a communication bus and a communication interface; where the processor, the readable storage medium and the communication interface communicate with each other via the communication bus; the readable storage medium is configured to store a program of performing the program step visualization implementation method in the simulation test process and the program causes the processor to perform operations corresponding to the program step visualization implementation method in the simulation test process.

As shown in FIG. 14, one or more embodiments further provide an electronic device, including a processor, a display communicating with the processor to present a graphics interface, and a readable storage medium; wherein,

> the readable storage medium is configured to store an instruction program;
> the processor is configured to execute the instruction program to perform the operations of: respectively setting a mark parameter of an activation state or a non-activation state corresponding to a corresponding execution state for each execution box in a graphics program; when the execution state of the execution box changes, changing a display mark of the execution box into an activation state mark corresponding to a new execution state; and when a current execution state of the execution box remains unchanged for a preset time period, changing the display mark of the execution box from the activation state mark into a non-activation state mark; the display is configured to display a graphics program via the graphics interface.

In some embodiments, the computer device, the industrial personal computer and apparatus may also be used as one of the electronic devices.

The structures shown in FIGS. 13 and 14 do not constitute any limitation to the electronic device, and the electronic device may further include more or less components than shown in the drawings or combine some components or have different component deployments.

In some embodiments, the communication interface may be RS232, RS485, USB interface or TYPE interface or the like, which may be connected with an external bus adapter. The communication interface may also include wired or wireless network interface. The network interface may optionally include wired interface and/or wireless interface (such as WI-FI interface, Bluetooth interface and the like), which is usually used to establish communication connection between the server and other computer devices.

The readable storage medium or the computer readable storage medium includes at least one type of memories. The memory includes flash memory, harddisk drive, multimedia card, card type memory (e.g. SD memory or the like), magnetic memory, magnetic disk or compact disk or the like. In some embodiments, the memory may be an internal storage unit in the computer device, for example, a harddisk drive of the computer device. In some other embodiments, the memory may also be an external storage device of the computer device, for example, a plug type hard disk drive, a smart media card (SMC), a secure digital (SD) card, a flash card or the like on the computer device. Furthermore, the memory may include both the internal storage unit in the computer device and the external storage device. The memory may be used to not only store an application software installed on the computer device and various types of data, for example, the codes of the computer program and the like but also temporarily store data already output or to be output.

In some embodiments, the processor may be a central processing unit (CPU), a processor, a controller, a microcontroller, a microprocessor or another data processing chip, which is used to run the program codes in the memory or process the data, for example, execute the computer program or the like.

In some embodiments, the communication bus may also be an input/output bus, which may be a Peripheral Component Interconnect (PCI) bus, or an Enhanced Industry Standard Architecture (EISA) bus or the like. The bus may include an address bus, a data bus and a control bus and the like.

Optionally, the computer device may also include a user interface, which may include a display, and an input unit, for example, a keyboard. Optionally, the user interface may also include a standard wired interface and wireless interface. Optionally, in some embodiments, the display may be an LED display, a liquid crystal display, a touch liquid crystal display and an Organic Light-Emitting Diode (OLED) touch display and the like. The display may also be appropriately referred to as display screen or display unit for displaying information processed in the computer device as well as a visual user interface.

The processor executes the program to perform the operations in the embodiments of the program step visualization implementation method in the simulation test process as shown in FIG. 1, for example, steps S101 to S102 shown in FIG. 1; alternatively, the processor is configured to execute the computer program to implement the functions of the modules or units in the above apparatus embodiments.

On or more embodiments of the present disclosure further provide a computer readable storage medium, which is configured to store a program of performing any one of the above possible program step visualization implementation methods in the simulation test process.

One or more embodiments of the present disclosure further provide a computer readable storage medium, which stores a computer readable instruction. The computer readable instruction is executed by at least one processor to perform the above program step visualization implementation method in the simulation test process, which specifically includes: respectively setting a mark parameter of an activation state or a non-activation state corresponding to a corresponding execution state for each execution box in a graphics program; when the execution state of the execution box changes, changing a display mark of the execution box into an activation state mark corresponding to a new execution state; and when a current execution state of the execution box remains unchanged for a preset time period, changing the display mark of the execution box from the activation state mark into a non-activation state mark. Reference can be made to the specific descriptions of the above program step visualization implementation method in the simulation test process and no redundant descriptions are made herein.

One or more embodiments further provide a computer program product, which includes a computer program or instruction. The computer program or instruction is executed on a computer to cause the computer to perform any one of the above possible program step visualization implementation methods in the simulation test process.

One or more embodiments further provide a computer program product, which includes a computer readable storage medium storing computer readable program codes. The computer readable program codes include instructions which cause at least one processor (one or more computer devices) to perform the operations of: respectively setting a mark parameter of an activation state or a non-activation state corresponding to a corresponding execution state for each execution box in a graphics program; when the execution state of the execution box changes, changing a display mark of the execution box into an activation state mark corresponding to a new execution state; and when a current execution state of the execution box remains unchanged for a preset time period, changing the display mark of the execution box from the activation state mark into a non-activation state mark.

In the several embodiments provided by the present disclosure, it should be understood that the disclosed device and method can be implemented another way. The above device embodiments are merely illustrative, for example, the flowcharts or block diagrams in the drawings show possible system architectures, functions and operations of the device, method, and computer program product in the several embodiments provided by the present disclosure. Thus, each block in the flowcharts or block diagrams may represent one module, one program fragment or one part of codes. The module, the program fragment or the part of codes includes one or more executable instructions for implementing the specified logic functions. It should be noted that in some alternative embodiments, the functions indicated in the blocks may also be performed in a sequence different from that indicated in the drawings. For example, two continuous blocks can be actually performed basically in parallel, and sometimes may be performed in a reverse sequence, which is dependent on the functions involved. It is further noted that each block in the block diagrams and/or flowcharts and the combinations of the blocks in the block diagrams and/or flowcharts may be implemented by a dedicated hardware-based system for executing specified functions or actions, or by combination of dedicated hardware and computer instructions.

Furthermore, the functional modules in the embodiments of the present disclosure can be integrated into one independent part, or exist as separate modules or two or more of the modules are integrated into one independent part.

The functions, when implemented by software function modules and sold or used as independent products, can be stored in one computer readable storage medium. Based on such understanding, the essence of technical solutions of the present disclosure, or a part contributing to the prior arts or a part of the technical solutions can be embodied in the form of software product. The computer software product is stored in one storage medium which includes several instructions to enable one computer device (for example, a personal computer, a server, or a network device or the like) to perform all or part of the steps of the method of each of the embodiments of the present disclosure.

Enlightened by the ideal embodiments of the present disclosure, relevant workers can, based on the contents of the specification, make various changes and modifications within the scope of protection of the technical idea of the present disclosure. The technical scope of the present disclosure is not limited to the contents of the specification but to the technical scope claimed by the claims.

## Claims

1. A program step visualization implementation method in a C code-based vehicle simulation test process, comprising:

   respectively setting a mark parameter of an activation state or a non-activation state corresponding to the corresponding execution state for each execution box in a C code-based graphics program; and
   when the execution state of the execution box changes, changing a display mark of the execution box into an activation state mark corresponding to the new execution state; and when a current execution state of the execution box remains unchanged for a preset period of time, changing the display mark of the execution box from the activation state mark into a non-activation state mark.

2. The method according to claim 1, wherein
   the mark parameter comprises a color parameter and/or a pattern parameter.

3. The method according to claim 2, wherein
   when the mark parameter is a color parameter, the method further comprises:

   respectively setting a color parameter of an activation state or a non-activation state corresponding to the corresponding execution state for each execution box in the graphics program;
   when the execution state of the execution box changes, changing a display color of the execution box into an activation state color corresponding to the new execution state; and
   when the current execution state of the execution box remains unchanged, changing the display color of the execution box from the activation state color into a non-activation state color gradually.

4. The method according to claim 2, wherein
   when the mark parameter is a pattern parameter and a pattern parameter type is a shape pattern of the execution box, the method in the simulation test process further comprises:

respectively setting a pattern parameter of an activation state or a non-activation state corresponding to the corresponding execution state for each execution box in the C code-based graphics program;

when the execution state of the execution box changes, changing the shape pattern of the execution box into an activation shape pattern corresponding to the new execution state; and

when the current execution state of the execution box remains unchanged, changing the shape pattern of the execution box from the activation shape pattern into a non-activation state shape pattern gradually.

5. The method according to claim 2, wherein
when the mark parameter is a pattern parameter and the type of the pattern parameter is a background fill pattern of the execution box, the method in the simulation test process further comprises:

respectively setting a pattern parameter of an activation state or a non-activation state corresponding to the corresponding execution state for each execution box in the C code-based graphics program;

when the execution state of the execution box changes, changing the background fill pattern of the execution box into an activation background fill pattern corresponding to the new execution state; and

when the current execution state of the execution box remains unchanged, changing the background fill pattern of the execution box from the activation background fill pattern into a non-activation state background fill pattern gradually.

6. The method according to claim 3, wherein
when the current execution state of the execution box remains unchanged, a method of changing the display color of the execution box from the activation state color into the non-activation state color gradually further comprises:

obtaining an execution time Ta of the current execution state;

setting a time span of gradually changing from the activation state color into the non-activation state color to T0;

taking three components R1, G1 and B1 from Red Green Blue (RGB) of the activation state color;

taking three components R2, G2 and B2 from RGB of the non-activation state color;

calculating three components R0, G0 and B0 of RGB of the display color of the execution box; and

combining the three components R0, G0 and B0 as the display color of the execution box corresponding to the current execution state.

7. The method according to claim 6, wherein;
a method of calculating the three components R0, G0 and B0 of the RGB of the display color of the execution box comprises:

calculating a lapsed time T;

wherein when T>T0, R0= R2, G0= G2, B0= B2; otherwise,

$$R0 = T/T0 * (R2 - R1) + R1;$$

$$G0 = T/T0 * (G2 - G1) + G1;$$

$$B0 = T/T0 * (B2 - B1) + B1.$$

8. The method according to claim 7, wherein
the execution state comprises an un-executed state, an in-execution state, execution completion with execution result marked as passed state, execution completion with execution result marked as failed state, an execution-interrupted state, and ongoing execution marked as failed state.

9. The method according to claim 8, wherein

the color parameters of the activation state or the non-activation state corresponding to the execution completion with execution result marked as failed state and the ongoing execution marked as failed state are the same and both are anomaly colors; and

if the execution box is in a unit group, when the execution state of any one execution box in the unit group is the execution completion with execution result marked as failed state or the ongoing execution marked as failed state, the display color of the unit group is an anomaly color.

10. A system, comprising a computer device, wherein the computer device further comprises:

a setting module, configured to respectively set a mark parameter of an activation state or a non-activation state corresponding to the execution state for each execution box in a C code-based graphics program;
a marking module, configured to: when the execution state of the execution box changes, change a display mark of the execution box into an activation state mark corresponding to the new execution state; and when a current execution state of the execution box remains unchanged for a preset period of time, change the display mark of the execution box from the activation state mark into the non-activation state mark.

11. A computer readable storage medium, storing a computer readable instruction, wherein the computer readable instruction is executed by at least one or more processors to perform the methods of any of claims 1-9.

12. An electronic device, comprising a processor, a readable storage medium, a communication bus and a communication interface; wherein the processor, the readable storage medium and the communication interface communicate with each other via the communication bus;
the readable storage medium is configured to store a program of performing the methods of any of claims 1-9, and the program causes the processor to perform operations corresponding to the method.

13. An electronic device, comprising a processor, a display communicating with the processor to present a graphics interface, and a readable storage medium; wherein,

the readable storage medium is configured to store a program of performing the methods of any of claims 1-9, and the program causes the processor to perform operations corresponding to the method;
the display is configured to display a graphics program through the graphics interface.

14. A computer program product, comprising:
a computer program or instruction, where the computer program or instruction is executed on a computer to cause the computer to perform the methods of any of claims 1-9.

| | S101 |
|---|---|
| a mark parameter of an activation state or a non-activation state corresponding to a corresponding execution state is set for each execution box in a graphics program respectively. | |

| | S102 |
|---|---|
| when the execution state of the execution box changes, a display mark of the execution box is changed into an activation state mark corresponding to a new execution state; and when a current execution state of the execution box remains unchanged for a preset time period, the display mark of the execution box is changed from the activation state mark into a non-activation state mark. | |

FIG. 1

Entry

OK

NOK

Connected? —N→ Disconnected

Y

Connected

FIG. 2

```
                    ┌─────────┐
                    │  Entry  │
                    └─────────┘
                         │
                         ▼
              ╱───────────────────╲
              ╲        OK          ╱
                ╲─────────────────╱
                         │
                         ▼
              ┌───────────────────┐
              │        NOK        │
              └───────────────────┘
                         │
                         ▼
              ◇───────────────────◇
              ╲    Connected?     ╱──N──►  ◇──────────────◇
              ◇───────────────────◇        ╲ Disconnected ╱
                         │                   ◇──────────────◇
                         Y
                         ▼
              ╱───────────────────╲
              ╲    Connected      ╱
                ╲─────────────────╱
```

FIG. 3

```
                    ┌─────────┐
                    │  Entry  │
                    └─────────┘
                         │
                         ▼
              ╱───────────────────╲
              ╲        OK          ╱
                ╲─────────────────╱
                         │
                         ▼
              ┌───────────────────┐
              │        NOK        │
              └───────────────────┘
                         │
                         ▼
              ◇───────────────────◇
              ╲    Connected?     ╱──N──►  ◇──────────────◇
              ◇───────────────────◇        ╲ Disconnected ╱
                         │                   ◇──────────────◇
                         Y
                         ▼
              ╱───────────────────╲
              ╲    Connected      ╱
                ╲─────────────────╱
```

FIG. 4

FIG. 5

FIG. 6

FIG. 7

FIG. 8

EP 4 567 606 A1

FIG. 9

FIG. 10

17

FIG. 11

setting module — marking module

FIG. 12

processor

communication bus

readable storage medium          communication interface

FIG. 13

readable storage medium — processor — display

FIG. 14

Europäisches
Patentamt

European
Patent Office

Office européen
des brevets

# EUROPEAN SEARCH REPORT

**Application Number**

EP 24 20 9621

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 7 464 373 B1 (YUNT MEHMET [US] ET AL) 9 December 2008 (2008-12-09) | 1-5, 10-14 | INV. G06F11/32 G06F8/34 G06F11/3668 |
| Y | * the whole document * | 6-9 | |
| Y | CN 104 217 452 A (ZHUHAI JUNTIAN ELECTRONIC TECH) 17 December 2014 (2014-12-17) * abstract; claim 5 * | 6,7 | G06F30/20 G06F30/12 G06F30/15 |
| Y | WO 2020/242618 A1 (MICROSOFT TECHNOLOGY LICENSING LLC [US]) 3 December 2020 (2020-12-03) * abstract * * paragraph [0035] - paragraph [0042] * | 8,9 | |

**TECHNICAL FIELDS SEARCHED (IPC)**

G06F

The present search report has been drawn up for all claims

| Place of search | Date of completion of the search | Examiner |
|---|---|---|
| Munich | 7 April 2025 | Salsa, Francesco |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 20 9621

This annex lists the patent family members relating to the patent documents cited in the above-mentioned European search report.
The members are as contained in the European Patent Office EDP file on
The European Patent Office is in no way liable for these particulars which are merely given for the purpose of information.

07-04-2025

| Patent document cited in search report | | Publication date | Patent family member(s) | | Publication date |
|---|---|---|---|---|---|
| US 7464373 | B1 | 09-12-2008 | US | 7464373 B1 | 09-12-2008 |
| | | | US | 9460239 B1 | 04-10-2016 |
| CN 104217452 | A | 17-12-2014 | NONE | | |
| WO 2020242618 | A1 | 03-12-2020 | CN | 113906394 A | 07-01-2022 |
| | | | EP | 3977288 A1 | 06-04-2022 |
| | | | US | 2020371906 A1 | 26-11-2020 |
| | | | WO | 2020242618 A1 | 03-12-2020 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202311468719